# EUROPÄISCHE PATENTSCHRIFT

(11) **EP 0 459 268 B1**
(45) Veröffentlichungstag und Bekanntmachung des Hinweises auf die Patenterteilung: **30.10.1996**
(21) Anmeldenummer: 91108177.6
(22) Anmeldetag: 21.05.1991
(51) Int. Cl.: G01R 33/38

(54) **Aktiv geschirmter Magnet**
Actively screened magnet
Aimant activement blindé

(30) Priorität: 31.05.1990 DE 4017599
(43) Veröffentlichungstag der Anmeldung: 04.12.1991
(73) Patentinhaber: SIEMENS AKTIENGESELLSCHAFT, 80333 München (DE)
(72) Erfinder: Söldner, Leonhard, Dr., W-8501 Schwaig (DE); Hentzelt, Heinz, W-8520 Erlangen (DE); Reichert, Thomas, Dipl.-Phys., W-8520 Erlangen (DE)

(56) Entgegenhaltungen:
- EP-A- 0 111 219
- EP-A- 0 251 342
- EP-A- 0 332 176
- US-A- 4 771 256
- PATENT ABSTRACTS OF JAPAN vol. 11, no. 173 (P-582)(2620) 04 Juni 1987, & JP-A-62 005161 (SHIMADZU CORP.) 12 Januar 1987

## Beschreibung

Die Erfindung betrifft einen aktiv geschirmten Magneten mit einem ein Nutzvolumen umschließenden Spulensystem, das aus je einem in Reihe geschalteten inneren und äußeren Spulensystem mit entgegengesetzten Magnetfeldrichtungen besteht, wobei die Magnetfeldrichtung im Nutzvolumen in Richtung der Längsachse des Magneten ausgerichtet ist und wobei der Magnet von einer magnetischen Flußrückführung umgeben ist, die parallel zu seiner Längsachse angeordnet ist, und die zusätzlich zwei an den beiden Polenden des Magneten senkrecht zu dessen Längsachse angeordnete ferromagnetische Platten aufweist.

Ein derartiger aktiv geschirmter Magnet ist aus der EP 0 332 176 A2 bekannt. Aus diesem Dokument ist es ferner bekannt, eine Flußrückführung lediglich in Form eines ferro-magnetischen Zylinders vorzusehen, der kürzer als das Spulensystem ist. Damit soll eine Störung des Magnetflusses an den Enden des Magneten vermieden werden.

Aus der JP-A-62005161 ist eine supraleitende Magnetanordnung mit aktiver Schirmung ohne Flußrückführung bekannt.

Die effektive Abschirmung des Streufeldes von Magneten ist insbesondere in der Kernspintomographie wesentlich, da dort mit sehr hohen Feldstärken von 0,5 T bis 4 T gearbeitet wird und die Sicherheitszone, in der das Streufeld einen gewissen Wert überschreitet, aus Platzgründen auf ein Mindestmaß begrenzt werden soll. Diese Sicherheitszone ist z.B. in Hinblick auf mögliche Einwirkung auf Herzschrittmacher, aber auch bezüglich der Beeinflussung anderer Geräte notwendig. Von besonderem Vorteil wäre es, die 0,5 mT-Streufeldlinie auf den Bereich eines Stockwerkes bzw. eines Raumes zu beschränken, so daß z.B. im Stockwerk über oder unter dem Kernspin tomographen auf dessen Installation keine Rücksicht mehr genommen werden muß.

Bisher wurden zur Abschirmung von Magneten insbesondere in der Kernspintomographie drei Methoden eingesetzt:

Bei der Raumabschirmung werden Platten aus magnetisierbarem Material an den Wänden und an der Decke des Magnetraumes angebracht. Hierzu ist jedoch ein erhebliches Eisenvolumen mit entsprechend hohem Gewicht erforderlich.

Bei der Direktabschirmung wird direkt am Magneten eine Flußrückführung angebracht. Eine derartige Flußrückführung ist beispielsweise in der EP-0 141 149 beschrieben. Dabei ist an den stirnseitigen Enden des zylinderförmigen Magneten jeweils ein scheibenförmiges Bauteil mit einer zentralen Öffnung vorgesehen. Diese scheibenförmigen Bauteile werden in Umfangsrichtung durch balkenartige ferro-magnetische Flußrückführungen verbunden. Auch diese Konstruktion weist ein erhebliches Gewicht auf, was insbesondere bei der Installation in bereits vorhandenen Räumen zu Problemen mit der zulässigen Deckenbelastbarkeit führen kann. Außerdem ist es kaum möglich, die 0,5 mT-Streufeldlinie auf ein Stockwerk bzw. einen Raum, d.h. im allgemeinen auf einen Radius < 2,5 m zu beschränken.

Aus der EP-Al-0 144 171 ist schließlich die aktive Schirmung von Magneten für die Kernspin-Tomographie bekannt. Hierbei werden konzentrisch zu den Nutzspulen Abschirmspulen angeordnet, die auf einem größeren Durchmesser als die Nutzspulen liegen und eine umgekehrte Durchflutung aufweisen. Damit kann nach außen das Streufeld stark reduziert werden. Bei Hochfeldmagneten z.B. mit einer Feldstärke > 1,5 T ist aber auch mit einer aktiven Schirmung allein die Beschränkung der 0,5 mT-Linie auf ein Stockwerk bzw. einen Raum nicht möglich.

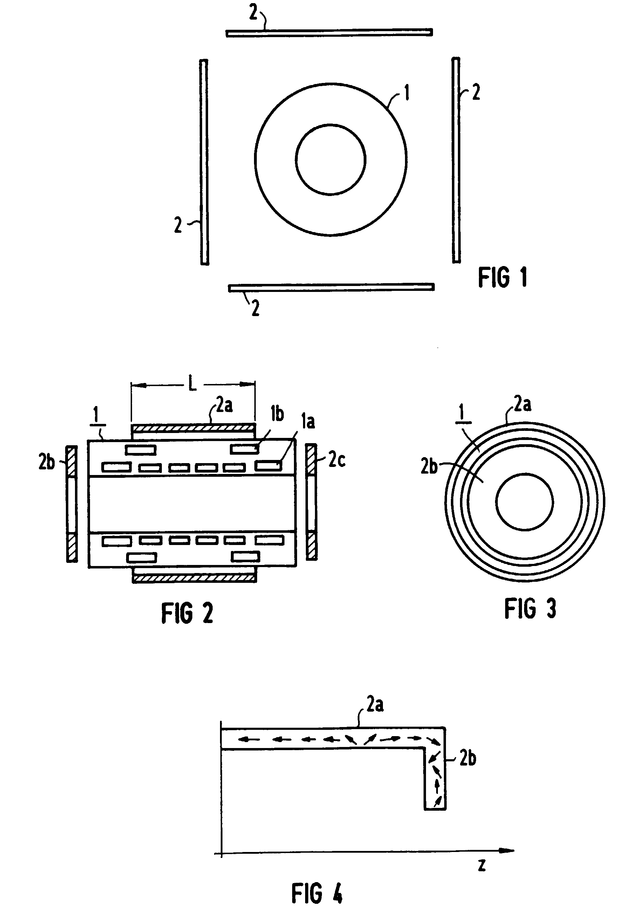

In der genannten EP-0 144 171 wurde auch bereits vorgeschlagen, zur weiteren Verbesserung der Abschirmwirkung aktiv geschirmte Magnete mit einer zusätzlichen ferro-magnetischen Abschirmung zu umgeben. Diese bekannte Anordnung ist in FIG 1 dargestellt. Dabei werden vier aufeinander senkrecht stehende Eisenplatten 2 parallel zur Längsachse des Magneten 1 angeordnet.

Aus der DE-Al-32 45 944 ist es bekannt, bei einem herkömmlichen, d.h. nicht aktiv geschirmten Elektromagneten zur Flußrückführung einen Zylindermantel vorzusehen, der endseitig mit ringförmigen Platten versehen ist. Zur Unterdrückung von Wirbelströmen ist der Zylindermantel aus einer Vielzahl axial angeordneter Ringscheiben aufgebaut.

Aufgabe der Erfindung ist es, bei einem aktiv geschirmten Magneten eine Abschirmung in Form einer Flußrückführung so auszugestalten, daß eine weiter verbesserte Abschirmwirkung erzielt wird.

Diese Aufgabe wird erfindungsgemäß dadurch gelöst, daß zwischen den parallel zur Längsachse des Magneten liegenden Teilen und den an den Polenden angeordneten Platten der Flußrückführung ein Spalt bleibt. Bei dieser Anordnung erreicht man eine gute Streufeldreduzierung mit geringen ferro-magnetischen Massen und einem verringerten Supraleiterbedarf für das Spulensystem.

Vorteilhafte Ausgestaltungen der Erfindung sind in den Unteransprüchen angegeben.

Die erfindungsgemäße Anordnung wird im folgenden anhand der FIG 2 bis 4 näher erläutert.

Die FIG 2 und 3 zeigen schematisch einen Magneten für die Kernspin-Tomographie mit einem inneren Spulensystem 1a und einem äußeren Spulensystem 1b. Dabei stellt FIG 2 einen Längschnitt, FIG 3 einen Querschnitt dar. Das äußere Spulensystem 1b dient zur Kompensation des Streufeldes, indem es ein Magnetfeld erzeugt, das dem Magnetfeld des inneren Spulensystems 1a entgegengerichtet ist und dieses nach außen weitgehend kompensiert.

Der Magnet 1 ist von einem hohlzylinderförmigen Teil 2a der Flußrückführung 2 umgeben. An den beiden Stirnseiten des Magneten, die die Magnetpole darstellen, ist jeweils eine kreisringförmige Platte 2b, 2c vorgesehen. Diese beiden Platten weisen eine innere Öffnung auf, die mindestens gleich der Öffnung des Magneten ist, um einen ungehinderten Zugang zum Nutzvolumen bzw. Untersuchungsraum des Magneten zu ermöglichen.

Für die Erfindung ist es wesentlich, daß sich der hohlzylinderförmige Teil 2a der Flußrückführung und die beiden Platten 2b und 2c nicht berühren, sondern daß vielmehr ein Luftspalt bleibt. Im Ausführungsbeispiel ist die Länge L des hohlzylinderförmigen Teiles 2a kleiner als der Abstand zwischen den beiden Platten 2b und 2c, und der äußere Durchmesser der beiden Platten 2b und 2c ist kleiner als der Innendurchmesser des hohlzylinderförmigen Teiles 2a.

Überraschenderweise hat sich herausgestellt, daß man mit einer derartigen Anordnung im Vergleich mit einer unmittelbaren Verbindung zwischen den Platten 2b und 2c und dem hohlzylinderförmigen Teil 2a die gleiche Streufeldreduzierung bei deutlich geringerem Aufwand an ferro-magnetischem Material erreicht. Die damit verbundene Gewichtsreduzierung stellt für viele Installationen ein entscheidendes Kriterium dar. Ferner wird auch der Supraleiterbedarf in den Spulensystemen 1a, 1b deutlich verringert.

Eine Begründung, warum die dargestellte Anordnung gegenüber einer geschlossenen Flußrückführung verbesserte Eigenschaften aufweist, wird im folgenden anhand von der FIG 4 gegeben. FIG 4 stellt einen Schnitt durch eine Kante einer geschlossenen Flußrückführung dar, bei der also das hohlzylinderförmige Teil 2a und die Platte 2c unmittelbar miteinander verbunden sind. Dabei ist schematisch jeweils die Flußrichtung in der Flußrückführung dargestellt. Wie man aus FIG 4 erkennt, werden an der Kante der Flußrückführung Flußkomponenten in Feldrichtung des Magneten erzeugt, die damit einen unerwünschten positiven Beitrag zum Streufeld liefern. Dieser Beitrag zum Streufeld muß durch eine zusätzliche Durchflutung im Spulensystem 1b zur aktiven Schirmung ausgeglichen werden. Damit ist jedoch zusätzlich zu einem hohen Eisenbedarf auch noch ein erhöhter Bedarf an Supraleiter-Material nötig.

Dieses Problem wird gemäß unserer Erfindung dadurch umgangen, daß die entsprechenden Eisenteile, die zu einem positiven Beitrag zum Streufeld führen würden, weggelassen werden.

## Patentansprüche

1. Aktiv geschirmter Magnet mit einem ein Nutzvolumen umschließenden Spulensystem, das aus je einem in Reihe geschalteten inneren und äußeren Spulensystem (1a, 1b) mit entgegengesetzten Magnetfeldrichtungen besteht, wobei die Magnetfeldrichtung im Nutzvolumen in Richtung der Längsachse des Magneten ausgerichtet ist und wobei der Magnet von einer magnetischen Flußrückführung (2) umgeben ist, die parallel zu seiner Längsachse angeordnet ist und die zusätzlich zwei an den beiden Polenden des Magneten senkrecht zu dessen Längsachse angeordnete ferro-magnetische Platten (2b, 2c) aufweist, **dadurch gekennzeichnet,** daß zwischen den parallel zur Längsachse des Magneten liegenden Teilen (2a) und den an den Polenden angeordneten Platten (2b, 2c) der Flußrückführung ein Spalt bleibt.

2. Aktiv geschirmter Magnet nach Anspruch 1, **dadurch gekennzeichnet,** daß bei einem zylinderförmigen Magneten der parallel zur Längsrichtung des Magneten liegende Teil der Flußrückführung (2a) als konzentrisch zum Magneten angeordneter Hohlzylinder ausgeführt ist und daß die an den Polenden des Magneten angeordneten Platten (2b, 2c) in Kreisringform ausgeführt sind.

3. Aktiv geschirmter Magnet nach Anspruch 2, **dadurch gekennzeichnet,** daß der Hohlzylinder (2a) kürzer ist als der Abstand zwischen den kreisringförmigen Platten (2b, 2c) und daß die kreisringförmigen Platten (2b, 2c) einen Außendurchmesser aufweisen, der kleiner als der Innendurchmesser des Hohlzylinders (2a) ist.

## Claims

1. Actively shielded magnet with a coil system surrounding a useful volume, which system in each case comprises a series-connected inner and outer coil system (1a, 1b) with opposite magnetic field directions, whereby the magnetic field direction in the useful volume is aligned in the direction of the longitudinal axis of the magnet and whereby the magnet is surrounded by a magnetic flux return (2) which is arranged parallel to its longitudinal axis and which additionally has two ferromagnetic plates (2b, 2c) arranged at the two pole ends of the magnet perpendicular to its longitudinal axis, characterized in that a gap remains between the parts (2a), lying parallel to the longitudinal axis of the magnet, and the plates (2b, 2c) of the flux return arranged at the pole ends.

2. Actively shielded magnet according to claim 1, characterized in that with a cylindrical magnet the part of the flux return (2a) lying parallel to the longitudinal direction of the magnet is designed as a hollow cylinder arranged concentrically to the magnet and in that the plates (2b, 2c) arranged at the pole ends of the magnet are designed in circular form.

3. Actively shielded magnet according to claim 2, characterized in that the hollow cylinder (2a) is shorter than the distance between the circular plates (2b, 2c) and in that the circular plates (2b, 2c) have an outer diameter which is smaller than the inner diameter of the hollow cylinder (2a).

## Revendications

1. Aimant à blindage actif, ayant un système de bobines entourant un volume utile, système constitué d'un système de bobines intérieures et d'un système de bobines extérieures (1a, 1b), montées en série, avec des directions opposées du champ magnétique, la direction du champ magnétique, dans le volume utile, étant dirigée dans la direction de l'axe longitudinal de l'aimant, l'aimant étant entouré d'un retour de flux magnétique (2), qui est disposé parallèlement à son axe longitudinal et comporte en outre deux plaques ferromagnétiques (2b, 2c), disposées contre les deux extrémités des pôles de l'aimant, perpendiculairement à son axe longitudinal, caractérisé en ce qu'il subsiste un interstice entre les pièces (2a), disposées parallèlement à l'axe longitudinal de l'aimant, et les plaques (2b, 2c), disposées aux extrémités des pôles, du retour de flux.

2. Aimant à blindage actif selon la revendication 1, caractérisé en ce que, dans le cas d'un aimant cylindrique, la pièce du retour de flux (2a), qui est disposée parallèlement à la direction longitudinale de l'aimant, est réalisée sous forme d'un cylindre creux disposé d'une manière concentrique à l'aimant, et que des plaques (2b, 2c), disposées aux extrémités des pôles de l'aimant, sont réalisées sous une forme annulaire.

3. Aimant à blindage actif selon la revendication 2, caractérisé en ce que le cylindre creux (2a) est plus court que la distance entre les plaques annulaires (2b et 2c) et que les plaques annulaires (2b, 2c) ont un diamètre extérieur plus petit que le diamètre intérieur du cylindre creux (2a).
